Europäisches Patentamt

European Patent Office

Office européen des brevets

(19)

(11) Veröffentlichungsnummer: **0 429 914 A2**

(12) **EUROPÄISCHE PATENTANMELDUNG**

(21) Anmeldenummer: 90121392.6

(51) Int. Cl.5: **H04B 1/10**

(22) Anmeldetag: 08.11.90

(30) Priorität: 01.12.89 DE 3939741

(43) Veröffentlichungstag der Anmeldung:
05.06.91 Patentblatt 91/23

(84) Benannte Vertragsstaaten:
AT CH DE ES FR GB IT LI Patentblatt 00/2

(71) Anmelder: TELEFUNKEN electronic GmbH
Theresienstrasse 2
W-7100 Heilbronn(DE)

(72) Erfinder: Küspert, Ludwig
Austrasse 7
W-8079 Hofstetten(DE)

(74) Vertreter: Maute, Hans-Jürgen, Dipl.-Ing.
TELEFUNKEN electronic GmbH
Theresienstrasse 2
W-7100 Heilbronn(DE)

(54) Tunerschaltung.

(57) Die Erfindung betrifft eine Tunerschaltung, insbesondere für Fernsehempfänger, mit einem Eingangsverstärker sowie einem Antennenanschluß zum Zuführen von Hochfrequenzsignalen. Erfindungsgemäß wird der Antennenanschluß über ein abstimmbares Bandfilter mit dem Eingangsverstärker verbunden, wobei dem Eingangsverstärker ein abstimmbares Zwischenkreisfilter nachgeschaltet wird. Hierbei wird die Eingangsstörfestigkeit der Tunerschaltung verbessert.

FIG. 2

EP 0 429 914 A2

## TUNERSCHALTUNG

Die Erfindung betrifft eine Tunerschaltung, insbesondere für Fernsehempfänger, mit einem Eingangsverstärker sowie einem Antennenanschluß zum Zuführen von Hochfrequenzsignalen.

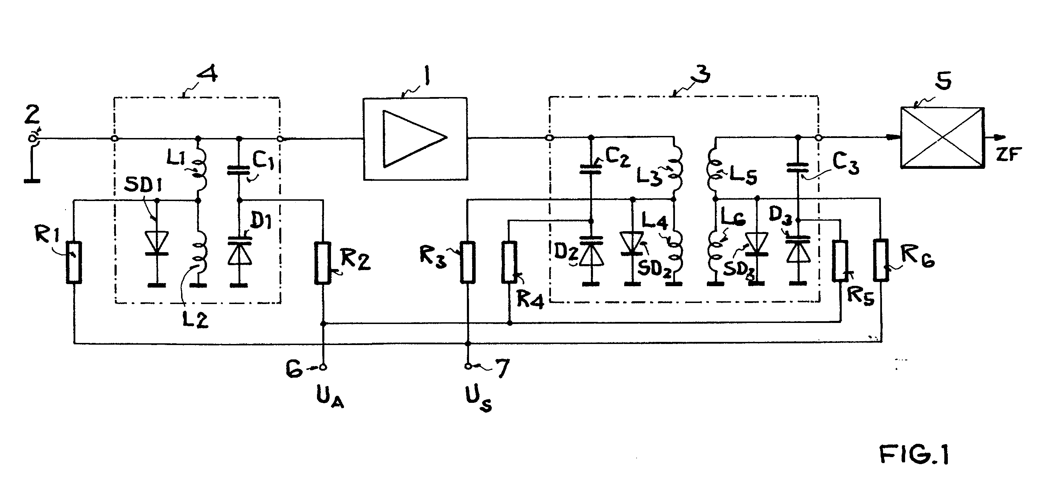

Die Erfindung geht von einer Tunerschaltung gemäß Figur 1 aus, wonach mit den Bezugszeichen 1, 2, 3, 4 und 5 ein Eingangsverstärker, ein Antennenanschluß, ein Bandfilter, ein Vorkreisfilter sowie eine Mischstufe bezeichnet ist, und das Vorkreisfilter 4 und das Bandfilter 3 abstimmbar sowie umschaltbar für zwei Frequenzbereiche sind. Ferner verbindet das Vorkreisfilter 4 den Antennenanschluß 2 mit dem Eingang des Eingangsverstärkers 1, während das Bandfilter 3 zwischen dem Eingangsverstärker 1 und der Mischstufe 5 geschaltet ist. Das Vorkreisfilter 4 ist mit den in Reihe geschalteten Abstimmspulen L1 und L2 sowie des Kondensators C1 und der zu diesem in Serie geschalteten Kapazitätsdiode D1 als Parallelschwingkreis aufgebaut, während das Bandfilter 3 als zweikreisiges Filter mit solchen Parallelschwingkreisen aufgebaut ist. Hierbei besteht der erste Parallelschwingkreis aus den in Reihe geschalteten Abstimmspulen L3 und L4 sowie einem Kondensator C2 und zu diesem in Serie geschalteten abstimmbarer Kapazitätsdiode D2 und der zweite Parallelschwingkreis aus den jeweils in Reihe geschalteten Spulen L5 und L6 sowie einem Kondensator C3 und einer abstimmbarer Kapazitätsdiode D3. Die Ankoppelpunkte dieser Reihenschaltkreise stellen jeweils die Verbindungspunkte des Schwingkreiskondensators mit der jeweiligen Abstimmspule dar.

Die Zuführung der Abstimmspannung $U_A$ an die abstimmbaren Kapazitätsdioden D1, D2 und D3 erfolgt jeweils über einen Widerstand R2, R4 und R5, die jeweils die Kathode der Kapazitätsdioden mit der Gleichspannungsklemme 6 verbinden. Zur Umschaltung der Frequenzbereiche ist jeweils der Verbindungspunkt der jeweils in Reihe geschalteten Abstimmspulen L1, L2 bzw. L3, L4 bzw. L5, L6 der Parallelschwingkreise einerseits mit der Anode einer Schaltdiode SD1 bzw. SD2 bzw. SD3 verbunden und andererseits über einen Widerstand R1 bzw. R3 bzw. R6 an eine Gleichspannungsklemme 7 zur Zuführung einer Schaltspannung $U_S$ angeschlossen. Die Umschaltung erfolgt dadurch, daß beim Anliegen einer positiven Schaltspannung $U_S$ die Schaltdioden SD1 bis SD3 in Durchlaßrichtung geschaltet sind, wodurch die Abstimmspulen L2, L4 und L6 hochfrequenzmäßig kurzgeschlossen werden. Demzufolge ist nur die Abstimmspule L1 für das Vorkreisfilter 4 und die Abstimmspulen L3 und L5 des Bandfilters 3 frequenzbestimmend, wogegen bei einer negativen Schaltspannung $U_S$ die Schaltdioden SD1 bis SD3 in den sperrenden Zustand überführt werden, mit der Folge, daß beide in Reihe geschalteten Spulen L1 und L2, L3 und L4 sowie L5 und L6 frequenzbestimmend sind. Hiernach betrifft der erste Fall einen hohen Frequenzbereich, während der zweite beschriebene Fall einen niederen Frequenzbereich betrifft, wobei mit Hilfe der Schaltspannung $U_S$ zwischen diesen beiden Frequenzbereichen umgeschaltet werden kann.

Diese Tunerschaltung gemäß Figur 1 zeigt, daß Störsignale nur durch eine Vorkreisselektion abgeschwächt werden und damit der Eingangsverstärker mehr belastet wird, mit der Folge, daß Eingangsstörfestigkeitsprobleme auftreten können.

Demzufolge besteht die Aufgabe der vorliegenden Erfindung darin, eine Tunerschaltung der eingangs genannten Art mit verbesserter Eingangsstörfestigkeit zu schaffen.

Die Lösung dieser Aufgabe ist durch die kennzeichnenden Merkmale des Anspruches 1 gegeben.

Bei der erfindungsgemäßen Tunerschaltung wird also dem Eingangsverstärker ein abstimmbares Bandfilter vorgeschaltet, während das dem Eingangsverstärker nachgeschaltete Filter ein einkreisiges Zwischenkreisfilter darstellt.

Vorteilhafte Weiterbildungen der erfindungsgemäßen Tunerschaltung sind den kennzeichnenden Merkmalen der Ansprüche 2 bis 6 entnehmbar.

Der Vorteil dieser Schaltungsanordnung liegt in den vor dem Eingangsverstärker wesentlich gesteigerten Selektionswerten und führt damit zu verbesserter Eingangsstörfestigkeit wie Kreuzmodulation und Intermodulation.

Im folgenden soll die Erfindung anhand von Ausführungsbeispielen in Verbindung mit den Zeichnungen näher erläutert werden. Hierbei zeigen:

Figur 2    ein Blockschaltbild eines Ausführungsbeispieles der erfindungsgemäßen Tunerschaltung,

Figur 3    ein Blockschaltbild eines weiteren Ausführungsbeispieles der erfindungsgemäßen Tunerschaltung und

Figur 4    ein Schaltbild eines weiteren Ausführungsbeispieles der erfindungsgemäßen Tunerschaltung.

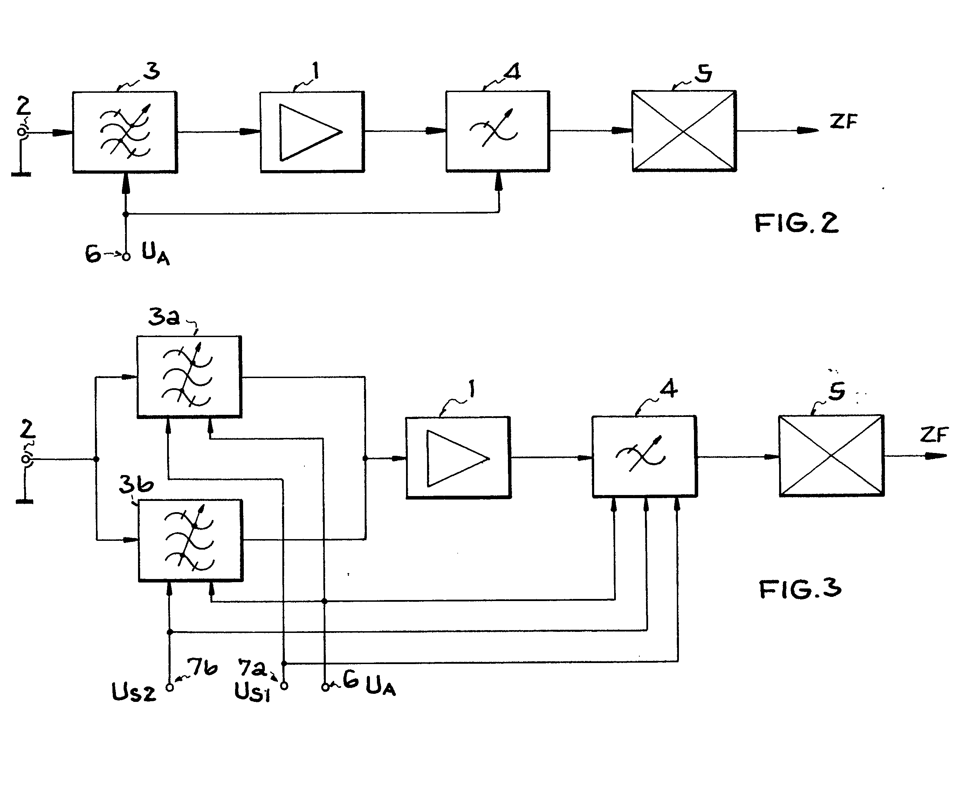

In Figur 2 ist mit den Bezugszeichen 1, 2, 3, 4 und 5 ein Eingangsverstärker, ein Antennenanschluß, ein Bandfilter, ein Zwischenkreisfilter und eine Mischstufe bezeichnet, wobei sowohl das Bandfilter 3 als auch das Zwischenkreisfilter 4 abstimmbar ausgeführt sind, indem diesen beiden Filtern über eine Gleichspannungsklemme 6 die Abstimmspannung $U_A$ zugeführt wird. Ferner ist am Ausgang der Mischstufe 5 die Zwischenfrequenz abgreifbar. Die am Antennenanschluß 2 empfangenen Hochfrequenzsignale werden dem Bandfilter 3 zugeführt, das seinerseits entsprechend der abgestimmten Frequenzsignale zur Verstärkung an die Eingangsverstärkerstufe 1 weiterleitet. Die verstärkten Hochfrequenzsignale werden dem Zwischenkreisfilter 4 zugeführt, das seinerseits mit der Mischstufe 5 verbunden ist.

Die Tunerschaltung gemäß Figur 3 weist im Gegensatz zu derjenigen der Figur 2 ein zweizügiges Bandfilter auf, das aus zwei parallel geschalteten Bandfiltern 3a und 3b aufgebaut ist. Die Antennensignale werden über den Antennenanschluß 2 den beiden Bandfiltern 3a und 3b zugeführt, die ihrerseits mit dem Eingang des Eingangsverstärkers 1 verbunden sind. Jedes Bandfilter 3a und 3b ist auf einen bestimmten Frequenzbereich abstimmbar, beispielsweise Bandfilter 3a für einen Frequenzbereich I und Bandfilter 3b für einen Frequenzbereich II, wobei diese Frequenzbereiche disjunkt festgelegt sein können. Um einen gewünschten Frequenzbereich empfangen zu können, ist das erste Bandfilter 3a als auch das dem Eingangsverstärker 1 direkt nachgeschaltete Zwischenkreisfilter 4 zwecks Zuführung einer ersten Schaltspannung $U_{S1}$ mit einer ersten Gleichspannungsklemme 7a verbunden, während zwecks Aktivierung des zweiten Bandfilters 3b - um also den Frequenzbereich II zu empfangen - dieses zweite Bandfilter 3b und das Zwischenkreisfilter 4 zwecks Zuführung einer zweiten Schaltspannung $U_{S2}$ mit einer zweiten Gleichspannungsklemme 7b verbunden ist. Somit lassen sich mit Hilfe der ersten und zweiten Schaltspannung $U_{S1}$ und $U_{S2}$ die gewünschten Frequenzbereiche einstellen, wobei zur Abstimmung auf eine bestimmte Empfangsfrequenz sowohl den Bandfiltern 3a und 3b als auch dem Zwischenkreisfilter 4 über eine Gleichspannungsklemme 6 eine Abstimmspannung $U_A$ zugeführt wird. Das am Ausgang des Zwischenkreisfilters 4 anstehende Nutzsignal wird entsprechend der Schaltung gemäß Figur 2 einer Mischstufe 5 zugeführt, die ihrerseits ein Zwischenfrequenzsignal erzeugt.

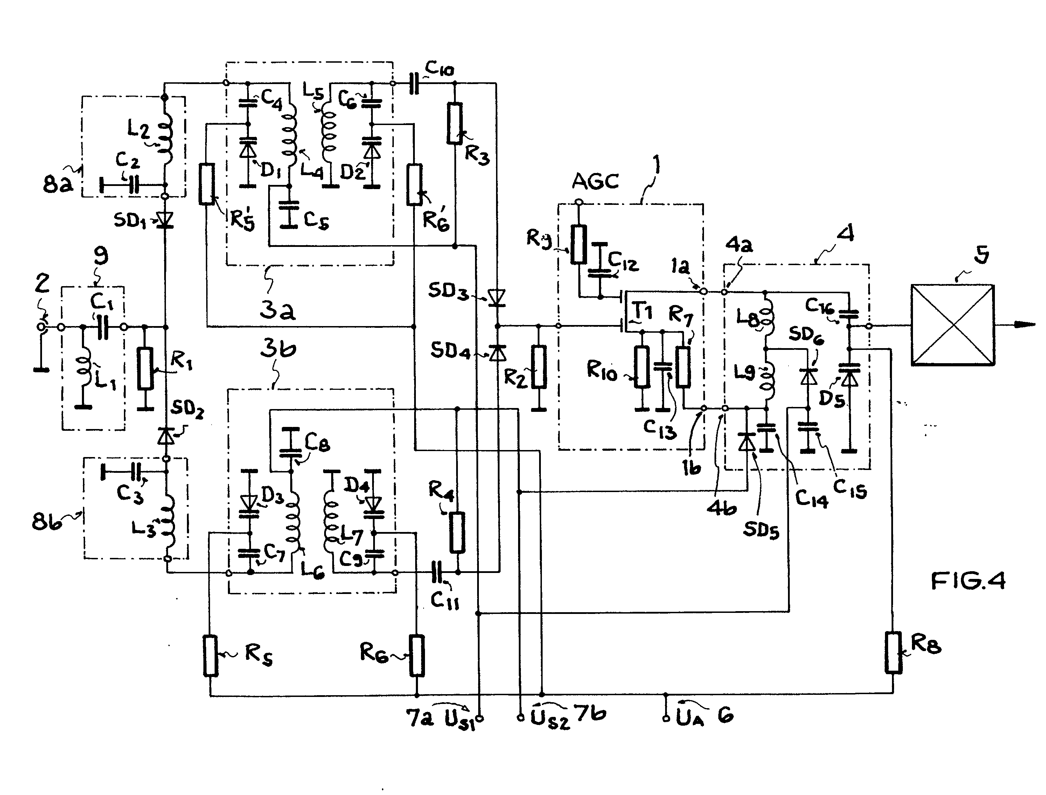

Das Ausführungsbeispiel gemäß der Figur 4 zeigt eine Tunerschaltung, deren Vorkreis entsprechend der Schaltung gemäß Figur 3 ebenfalls ein zweizügiges Bandfilter 3a und 3b aufweist. Auch ist wie dort mit den Bezugszeichen 1, 2, 4 und 5 eine Eingangsverstärkerschaltung, ein Antennenanschluß, ein Zwischenkreisfilter und eine Mischstufe bezeichnet. Ferner ist dem Antennenanschluß 2 direkt ein Hochpaß 9 nachgeschaltet und dem ersten bzw. zweiten Bandfilter 3a bzw. 3b ein erster bzw. zweiter Tiefpaß 8a bzw. 8b vorgeschaltet.

Der Hochpaß 9 besteht aus einem Kondensator C1 und einer Spule L1, wobei der Kondensator C1 die Hochfre quenzsignale in die nachfolgende Schaltungsgruppe einkoppelt und die Spule L1 die Gleichspannungsanteile auf das Bezugspotential der Schaltung abführt. Der Ausgang des Hochpasses 9 ist sowohl über eine erste Schaltdiode SD1 mit dem Eingang des ersten Tiefpasses 8a und über eine zweite Schaltdiode SD2 mit dem Eingang des zweiten Tiefpasses 8b als auch über einen ersten Widerstand R1 mit dem Bezugspotential der Schaltung verbunden, wobei die Kathoden der beiden Schaltdioden SD1 und SD2 an den Ausgang des Hochpasses 9 angeschlossen sind und deren Anoden jeweils mit dem ersten bzw. zweiten Tiefpaß 8a bzw. 8b verbunden sind.

Der erste bzw. zweite Tiefpaß 8a bzw. 8b besteht aus einem Kondensator C2 bzw. C3 und einer Spule L2 bzw. L3, wobei die Spule L2 bzw. L3 im Signalweg liegt und der Kondensator C2 bzw. C3 gegen Masse geschaltet ist.

Die beiden Bandfilter 3a und 3b sind ebenfalls identisch aufgebaut und enthalten jeweils zwei Parallelschwingkreise. Der erste Parallelschwingkreis des ersten bzw. zweiten Bandfilters 3a bzw. 3b ist aus einer Reihenschaltung aus einer Abstimmspule L4 bzw. L6 und einem Kondensator C5 bzw. C8 und einer hierzu parallel geschalteten Reihenschaltung aus einem Kondensator C4 bzw. C7 und einer abstimmbaren Kapazitätsdiode D1 bzw. D3 aufgebaut, während der zweite Parallelschwingkreis hierzu entsprechend mit der Reihenschaltung aus einer Abstimmspule L5 bzw. L7 und der Reihenschaltung aus einem Kondensator C6 bzw. C9 und einer Kapazitätsdiode D2 bzw. D4 aufgebaut ist. Die Hochfrequenzsignale werden aus dem ersten bzw. zweiten Bandfilter 3a bzw. 3b jeweils mittels eines Koppelkondensators C10 bzw. C11 ausgekoppelt und jeweils über eine dritte bzw. vierte Schaltdiode SD3 bzw. SD4 dem Eingang des Eingangsverstärkers 1 zugeführt. Diese beiden Schaltdioden SD3 und SD4 sind mit ihren Kathoden mit dem Eingang der Eingangsverstärkerschaltung 1 verbunden und zusätzlich über einen zweiten Widerstand R2 auf das Bezugspotential der Schaltung gelegt. Schließlich ist der Verbindungspunkt zwischen dem Koppelkondensator C10 des ersten Bandfilters 3a und der dritten Schaltdiode SD3 sowie der Verbindungspunkt zwischen dem Koppelkondensator C11 des zweiten Bandfilters 3b und der vierten Schaltdiode SD4 über einen dritten bzw. vierten Widerstand R3 bzw. R4 mit einer ersten bzw. zweiten Gleichspannungsklemme 7a bzw. 7b zur Zuführung einer ersten bzw. zweiten Schaltspannung $U_{S1}$ bzw. $U_{S2}$ verbunden. Ferner ist auch der Verbindungspunkt der Abstimmspule L4 bzw. L6 und des Kondensators C5 bzw. C8 des ersten Parallelschwingkreises des ersten bzw. zweiten Bandfilters 3a bzw. 3b ebenfalls an die erste bzw. zweite Gleichspannungsklemme 7a bzw. 7b angeschlossen. Zur Zuführung der Abstimmspannung $U_A$ ist der Verbindungspunkt des Kondensators C4 bzw. C7 mit der Kapazitätsdiode D1 bzw. D3 des ersten Parallelschwingkreises sowie der Verbindungspunkt des Kondensators C6 bzw. C9 mit der Abstimmdiode D2 bzw. D4 des zweiten Parallelschwingkreises des ersten bzw. zweiten Bandfilters 3a bzw. 3b über einen Widerstand R5 sowie einem Widerstand R6 mit einer Gleichspannungsklemme 6 zur Zuführung einer Abstimmspannung $U_A$ verbunden.

Die Eingangsverstärkerschaltung 1 ist aus einem Dualgate-Feldeffekttransistor T1 aufgebaut, dessen erste Gate-Elektrode den Eingang dieser Schaltung darstellt und der zweiten Gate-Elektrode über einen Widerstand R9 ein AGC-Signal zugeführt wird, wobei zusätzlich diese zweite Gate-Elektrode über einen Kondensator C12 mit dem Bezugspotential der Schaltung verbunden ist. Die Drain-Elektrode dieses Feldeffekttransistors T1 stellt den Ausgang 1a dieser Schaltung dar, während die Source-Elektrode über einen Widerstand R7 mit der Klemme 1b dieser Eingangsverstärkerschaltung 1 verbunden ist, wobei diese Source-Elektrode sowohl über einen Widerstand R10 als auch über einen Kondensator C13 mit dem Bezugspotential der Schaltung verbunden ist.

Das Zwischenkreisfilter 4 besteht ebenfalls wie die Bandfilter 3a bzw. 3b aus einem Parallelschwingkreis, in dem eine Reihenschaltung aus zwei Abstimmspulen L8 und L9 parallel mit der Reihenschaltung aus einem Kondensator C16 und einer Kapazitätsdiode D5 geschaltet ist. Der Verbindungspunkt der Abstimmspule L8 und des Kondensators C16 stellt den Eingang 4a dieses Zwischenkreisfilters 4 dar, der mit dem Ausgang 1a der Eingangsverstärkerschaltung 1 verbunden ist, während der Fußpunkt der zweiten Abstimmspule L9 sowohl über einen Kondensator C14 mit dem Bezugspotential der Schaltung als auch mit der Eingangsklemme 4b dieser Schaltung verbunden ist. Diese Eingangsklemme 4b des Zwischenkreisfilters 4 ist an die Klemme 1b der Eingangsverstärkerschaltung 1 angeschlossen. Weiterhin ist der Verbindungspunkt der ersten und zweiten Abstimmspule L8 und L9 an die Kathode einer Schaltdiode SD6 angeschlossen, deren Anode über einen Kondensator C15 sowohl mit dem Bezugspotential der Schaltung als auch mit der ersten Gleichspannungsklemme 7a verbunden ist. Darüber hinaus ist die Eingangsklemme 4b an die Kathode einer weiteren Schaltdiode SD5 angeschlossen, deren Anode mit der zweiten Gleichspannungsklemme 7b verbunden ist. Schließlich ist der Verbindungspunkt des Kondensators C16 mit der Kapazitätsdiode D5 über einen Widerstand R8 mit der Gleichspannungsklemme 6 verbunden und stellt zusätzlich den Ausgang des Zwischenkreisfilters 4 dar, der seinerseits mit einer Mischstufe 5 zur Erzeugung eines Zwischenfrequenzsignales verbunden ist.

Die erste und zweite Schaltspannung $U_{S1}$ bzw.

$U_{S2}$ dient zum Aktivieren des Bandfilters 3a bzw. 3b sowie zur Einstellung des entsprechenden Frequenzbereiches des Zwischenkreisfilters 4, wie schon in der Beschreibung zur Schaltung der Figur 3 dargelegt wurde. Zur Aktivierung des ersten Bandfilters 3a wird an die erste Gleichspannungsklemme 7a eine positive Schaltspannung $U_{S1}$ angelegt, wodurch die erste und dritte Schaltdiode SD1 und SD3 in Durchlaßrichtung geschaltet werden, wobei die entsprechenden Gleichstromkreise über den ersten bzw. zweiten Widerstand R1 bzw. R2 geschlossen werden. Mittels der positiven Schaltspannung $U_{S1}$ wird ebenfalls die Schaltdiode SD6 des Zwischenkreisfilters 4 in Durchlaßrichtung geschaltet, wodurch die Abstimmspule L9 hochfrequenzmäßig kurzgeschlossen wird. Nun bestimmt nur die Abstimmspule L8 den Frequenzbereich des Zwischenkreisfilters 4.

Liegt dagegen an der zweiten Gleichspannungsklemme 7b eine positive Schaltspannung $U_{S2}$ wird das zweite Bandfilter 3b aktiviert, da nun die beiden Schaltdioden SD2 und SD4 in Durchlaßrichtung und die beiden Schaltdioden SD1 und SD3 in Sperrichtung geschaltet sind, wodurch nun zwei Gleichstromkreise über den Widerstand R4, der Schaltdiode SD4 und dem Widerstand R2 sowie über die Abstimmspule L6, dem Tiefpaß 8b, der Schaltdiode SD2 und dem Widerstand R1 entstehen. Zusätzlich wird die Schaltdiode SD5 des Zwischenkreisfilters 4 ebenfalls in Durchlaßrichtung geschaltet, mit der Folge, daß nun beide in Reihe geschalteten Abstimmspulen L8 und L9 frequenzbestimmend sind.

Schließlich wird eine Abstimmspannung $U_A$ über eine Gleichspannungsklemme 6 und jeweils einem Widerstand R5, R5', R6, R6' und R8 den Kathoden der Kapazitätsdioden D1 und D3, den Kapazitätsdioden D2 und D4 sowie der Kapazitätsdiode D5 zugeführt.

Ein weiterer Vorteil der erfindungsgemäßen Tunerschaltung besteht darin, daß das Zwischenkreisfilter 4 mit breiter Resonanzkurve ausgebildet werden kann und damit der Abgleich erleichtert und auch die Großsignalfestigkeit der Mischstufe um den Betrag der Einfügedämpfung gesteigert wird.

## Ansprüche

1. Tunerschaltung, insbesondere für Fernsehempfänger, mit einem Eingangsverstärker (1) sowie einem Antennenanschluß (2) zum Zuführen von Hochfrequenzsignalen, dadurch gekennzeichnet, daß der Antennenanschluß (2) über ein abstimmbares Bandfilter (3) mit dem Eingangsverstärker (1) verbunden wird, und daß dem Eingangsverstärker (1) ein abstimmbares Zwischenkreisfilter (4) nachgeschaltet wird.

2. Tunerschaltung nach Anspruch 1, dadurch gekennzeichnet, daß das abstimmbare Bandfilter (3) aus zwei abstimmbaren, parallel geschalteten Bandfiltern (3a, 3b) aufgebaut ist.

3. Tunerschaltung nach Anspruch 2, dadurch gekennzeichnet, daß zur Aktivierung der beiden Bandfilter (3a, 3b) jeweils ein Paar Schaltdioden (SD1, SD3 bzw. SD2, SD4) vorgesehen sind, und daß das abstimmbare Zwischenkreisfilter (4) zur Anpassung an das jeweils aktivierte Bandfilter (3a, 3b) zwei weitere Schaltdioden (SD5, SD6) aufweist.

4. Tunerschaltung nach einem der Ansprüche 2 oder 3, dadurch gekennzeichnet, daß den Bandfiltern (3a, 3b) jeweils ein Tiefpaß (8a, 8b) vorgeschaltet ist.

5. Tunerschaltung nach einem der vorangehenden Ansprüche, dadurch gekennzeichnet, daß der Antennenanschluß (2) mit einem Hochpaß (9) verbunden ist.

6. Tunerschaltung nach einem der Ansprüche 3 bis 5, dadurch gekennzeichnet, daß der Antennenanschluß (2) mit dem Eingang des Hochpasses (9) verbunden ist, daß der Ausgang des Hochpasses (9) über einen ersten Widerstand (R1) mit dem Bezugspotential der Schaltung verbunden ist und an die Kathoden der ersten und zweiten Schaltdiode (SD1, SD2) angeschlossen ist, daß die Anode der ersten bzw. zweiten Schaltdiode (SD1 bzw. SD2) mit dem Eingang des ersten bzw. zweiten Tiefpasses (8a bzw. 8b) verbunden ist, daß der Ausgang des ersten bzw. zweiten Tiefpasses (8a bzw. 8b) mit dem Eingang des ersten bzw. zweiten Bandfilters (3a bzw. 3b) verbunden ist, daß der Ausgang des ersten bzw. zweiten Bandfilters (3a bzw. 3b) über einen ersten bzw. zweiten Koppelkondensator (C10 bzw. C11) mit der Anode der dritten bzw. vierten Schaltdiode (SD3 bzw. SD4) verbunden ist, daß die Kathode der dritter bzw. vierten Schaltdiode (SD3 bzw. SD4) über einen zweiten Widerstand (R2) mit dem Bezugspotential der Schaltung verbunden ist als auch an den Eingang des Eingangsverstärkers (1) angeschlossen ist, daß die Anode der dritten bzw. vierten Schaltdiode (SD3 bzw. SD4) über einen dritten bzw. vierten Widerstand (R3 bzw. R4) mit einer ersten bzw. zweiten Gleichspannungsklemme (7a, 7b) zur Zuführung einer ersten bzw. zweiten Schaltspannung ($U_{S1}$ bzw. $U_{S2}$) verbunden ist, daß die Anode der ersten bzw. zweiten Schaltdiode (SD1 bzw. SD2) über den ersten bzw. zweiten Tiefpaß (8a bzw. 8b) und einer ersten Abstimmspule (L4 bzw. L6) des ersten bzw. zweiten Bandfilters (3a bzw. 3b) mit der ersten bzw. zweiten Gleichspannungsklemme (7a, 7b) als auch über jeweils einen Kondensator (C5 bzw. C8) mit dem Bezugspotential der Schaltung verbunden ist, daß die Kathoden von ersten Abstimmdioden (D1, D3) des ersten und zweiten Bandfilters (3a, 3b) bzw. die Kathoden von zweiten Abstimmdioden (D2, D4) des ersten und zweiten Bandfilters (3a, 3b) über einen fünften bzw. sechsten Widerstand (R5 bzw. R6) mit einer dritten Gleichspannungsklemme (6) zur Zuführung einer Abstimmspannung ($U_A$) verbunden sind, daß eine Reihenschaltung aus einer ersten und zweiten Abstimmspule (L8, L9) des Zwischenkreisfilters (4) einen Eingang (4a) mit einer Anschlußklemme (4b) dieses Zwischenkreisfilters (4) verbindet, daß die Anschlußklemme (4b) des Zwischenkreisfilters (4) über einen Kondensator (C14) mit dem Bezugspotential verbunden ist und über eine fünfte Schaltdiode (SD5) an die zweite Gleichspannungsklemme (7b) angeschlossen ist, wobei deren Kathode mit der Anschlußklemme (4b) des Zwischenkreisfilters (4) verbunden ist, daß am Verbindungspunkt der ersten und zweiten Abstimmspule (L8, L9) des Zwischenkreisfilters (4) die Kathode einer sechsten Schaltdiode (SD6) angeschlossen ist, wobei deren Anode sowohl mit der ersten Gleichspannungsklemme (7a) als auch über einen weiteren Kondensator (C15) mit dem Bezugspotential der Schaltung verbunden ist, daß eine Reihenschaltung aus einem Schwingkreiskondensator (C16) und einer fünften Abstimmdiode (D5) in Serie zu der ersten und zweiten Abstimmspule (L8, L9) des Zwischenkreisfilters (4) geschaltet ist, wobei der Kondensator (C16) mit der ersten Abstimmspule (L8) und die Kathode der Abstimmdiode (D5) mit dem Kondensator (C16) verbunden ist, daß die Kathode der fünften Abstimmdiode (D5) über einen achten Widerstand (R8) mit der dritten Gleichspannungsklemme ($U_A$) verbunden ist, daß der Verbindungspunkt von Schwingkreiskondensator (C16) und der fünften Abstimmdiode (D5) den Ausgang des Zwischenkreisfilters (4) darstellt.

FIG.1

EP 0 429 914 A2

FIG.2

FIG.3

7

FIG.4

EP 0 429 914 A2